# EUROPEAN PATENT SPECIFICATION

(11) **EP 4 272 988 B1**
(45) Date of publication and mention of the grant of the patent: **18.12.2024**
(21) Application number: 23169333.4
(22) Date of filing: 21.04.2023
(51) Int. Cl.: B60K 35/00, B60K 35/10, B60K 35/29

(54) **OPERATION CONTROL DEVICE, OPERATION DEVICE, STEERING DEVICE, VEHICLE, OPERATION CONTROL METHOD, AND STORAGE MEDIUM**
BETRIEBSSTEUERUNGSVORRICHTUNG, BETRIEBSVORRICHTUNG, LENKVORRICHTUNG, FAHRZEUG, BETRIEBSSTEUERUNGSVERFAHREN UND SPEICHERMEDIUM
DISPOSITIF DE COMMANDE DE FONCTIONNEMENT, DISPOSITIF DE FONCTIONNEMENT, DISPOSITIF DE DIRECTION, VÉHICULE, PROCÉDÉ DE COMMANDE DE FONCTIONNEMENT ET SUPPORT D'INFORMATIONS

(30) Priority: 28.04.2022 JP 2022075187
(43) Date of publication of application: 08.11.2023
(73) Proprietor: TOYOTA JIDOSHA KABUSHIKI KAISHA, Toyota-shi, Aichi-ken, 471 8571 (JP)
(72) Inventor: KOZONO, Yuki, TOYOTA-SHI, AICHI-KEN, 471-8571 (JP); NAKAJIMA, Shu, TOYOTA-SHI, AICHI-KEN, 471-8571 (JP); YAMADA, Tomio, NIWA-GUN, AICHI-KEN, 480-0134 (JP)
(74) Representative: Cabinet Beau de Loménie

(56) References cited:
- JP-A- 2007 106 353
- JP-A- 2020 057 540

## Description

### BACKGROUND

### Technical Field

This invention relates to an operation control device, an operation device, a steering device, a vehicle, an operation control method, and an operation control program storage medium.

### Related Art

Japanese Patent Application Laid-open (JP-A) No. 2020-057540 discloses an operation device that includes a push switch and a touch switch. The push switch has a first operation surface and detects push operations performed on the first operation surface. The touch switch has an adjacent operation surface adjacent to the first operation surface and detects touch operations performed on the adjacent operation surface. The operation device performs control to not accept a touch operation performed on the touch switch for a predetermined period of time after receiving a push operation performed on the push switch.

In the operation device disclosed in JP-A No. 2020-057540, when the user consecutively performs operations with respect to the push switch of the first operation surface and the touch switch of the adjacent operation surface, even if the operations performed were intentional operations and not erroneous operations, the operation with respect to the touch switch has sometimes ended up being canceled, leaving the user with a feeling that something is wrong.

The document JP 2007 106353 A discloses a comparable operation control device.

### SUMMARY

This invention has been made in consideration of the above circumstances and provides an operation control device, an operation device, a steering device, a vehicle, an operation control method, and an operation control program storage medium that may more effectively limit execution of processes corresponding to unintended operations.

The operation control device includes a memory; and a processor connected to the memory, the processor being configured to: in a case in which the processor receives, at an operation unit that includes a first operation region and a second operation region adjacent to the first operation region, an operation performed on the first operation region in a direction of the second operation region, limit execution of processes corresponding to operations performed on the second operation region until a predetermined condition is met.

In a configuration where the operation unit includes the first operation region and the second operation region adjacent to the first operation region, when an operation performed on the first operation region is an operation in the direction of the second operation region, the probability that an operation subsequently performed on the second operation region is an unintended operation becomes higher. Based on this, in a case in which the processor receives an operation performed on the first operation region in the direction of the second operation region, the processor limits execution of processes corresponding to operations performed on the second operation region until the predetermined condition is met. Because of this, execution of processes corresponding to unintended operations may be more effectively limited.

The processor is configured not to limit execution of processes corresponding to operations performed on the second operation region in a case in which the processor receives an operation performed on the first operation region in a direction other than the direction of the second operation region.

In a case in which an operation performed on the first operation region is an operation in a direction other than the direction of the second operation region, the probability that an operation subsequently performed on the second operation region is an intended operation is high. Based on this, in the second aspect, in a case in which the processor receives an operation performed on the first operation region in a direction other than the direction of the second operation region, the processor does not limit execution of processes corresponding to operations performed on the second operation region. Because of this, intended operations may be inhibited from ending up being canceled.

The first operation region includes a wheel switch, and the processor limits execution of processes corresponding to operations performed on the second operation region in a case in which the processor receives a rotational operation with respect to the wheel switch in the direction of the second operation region.

In a configuration where the first operation region is provided with the wheel switch, execution of processes corresponding to unintended operations may be more effectively limited.

The processor is configured not to limit execution of processes corresponding to operations performed on the second operation region in a case in which the processor receives at least one of a rotational operation with respect to the wheel switch in the opposite direction of the direction of the second operation region or a push operation on the wheel switch.

In a configuration where the first operation region is provided with the wheel switch, intended operations may be inhibited from ending up being canceled.

The predetermined condition is a condition where a predetermined amount of time has elapsed.

In a case in which the processor receives an operation performed on the first operation region in the direction of the second operation region, the processor limits execution of processes corresponding to operations performed on the second operation region until the predetermined amount of time elapses. Because of this, limiting execution of processes corresponding to unintended operations may be realized by a simple process.

The predetermined condition is a condition where an operation performed on the second operation region has been discontinued.

In a case in which the processor receives an operation performed on the first operation region in the direction of the second operation region, the processor limits execution of processes corresponding to operations performed on the second operation region until an operation performed on the second operation region is discontinued. Because of this, after performing on operation with respect to the first operation region in the direction of the second operation region, when the user continues an unintended operation with respect to the second operation region, such as continuing to touch the second operation region for example, execution of the process corresponding to that unintended operation may be limited.

The predetermined condition is a condition where an amount of time decided in accordance with the speed of an operation performed on the first operation region has elapsed.

In a case in which an unintended operation is performed on the second operation region after an operation has been performed with respect to the first operation region in the direction of the second operation region, the amount of time until the operation is performed on the second operation region after the operation has been performed on the first operation region is correlated to the speed of the operation performed on the first operation region. Based on this, in the seventh aspect, in a case in which the processor receives an operation performed on the first operation region in the direction of the second operation region, the processor limits execution of processes corresponding to operations performed on the second operation region until an amount of time decided in accordance with the speed of the operation performed on the first operation region elapses. Because of this, it becomes possible to optimize, in accordance with the speed of operations performed on the first operation region, the period of time in which the processor limits execution of processes performed on the second operation region.

### BRIEF DESCRIPTION OF THE DRAWINGS

FIG. 1 is a block diagram illustrating the schematic configuration of an in-vehicle system pertaining to embodiments;
FIG. 2 is a perspective view of a front portion of a cabin of a vehicle as seen from the vehicle rear side;
FIG. 3 is an enlarged view illustrating part of a steering wheel;
FIG. 4 is an illustration of an example of an image of a switch group displayed on a HUD and a meter display;
FIG. 5 is a functional block diagram of an operation control ECU;
FIG. 6 is a flowchart illustrating a timing process pertaining to a first embodiment;
FIG. 7 is an illustration of an example where a thumbwheel switch is rotated downward;
FIG. 8 is a flowchart illustrating a touch information output process pertaining to the first embodiment;
FIG. 9 is an illustration of an example of an image of a switch group displayed on the HUD and the meter display;
FIG. 10 is a flowchart illustrating a touch information output process pertaining to a second embodiment;
FIG. 11 is a flowchart illustrating a timing process pertaining to a third embodiment; and
FIG. 12 is a plan view illustrating an example of a range in which an operation performed on a first operation region is regarded as an operation in the direction of a second operation region.

### DETAILED DESCRIPTION

Exemplary embodiments of the invention will be described in detail below with reference to the drawings.

### [First Embodiment]

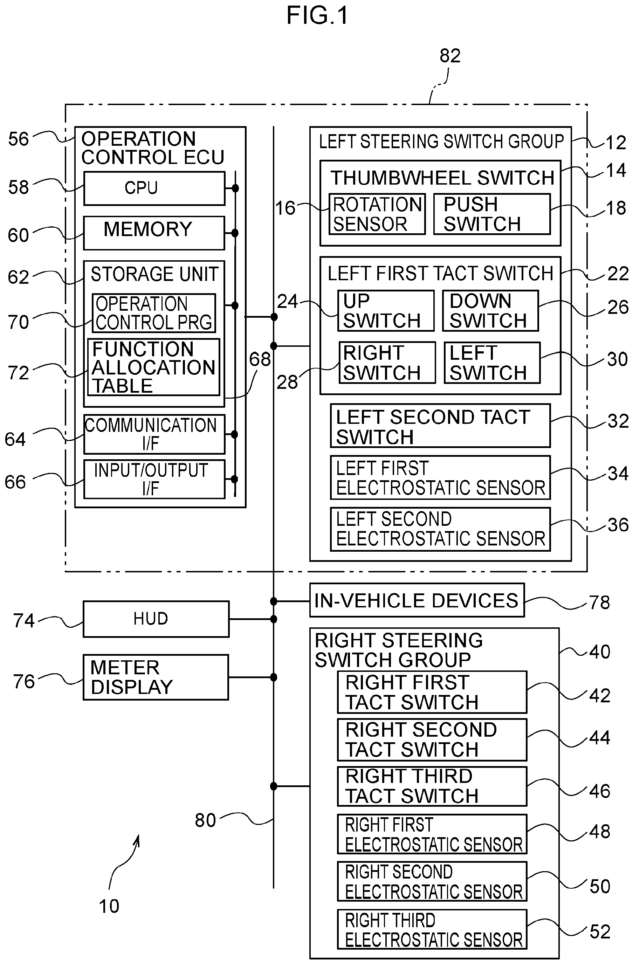

FIG. 1 illustrates an in-vehicle system 10 pertaining to the embodiment. The in-vehicle system 10 includes a left steering switch group 12 and a right steering switch group 40, an operation control electronic control unit (ECU) 56, a head-up display (HUD) 74, a meter display 76, and in-vehicle devices 78.

The left steering switch group 12, the right steering switch group 40, the operation control ECU 56, the HUD 74, the meter display 76, and the in-vehicle devices 78 are connected to a system bus 80 so as to be communicable with each other. The in-vehicle devices 78 include, for example, devices such as an air conditioner, an audio device, a car navigation system, and a voice input device.

It will be noted that in this embodiment the left steering switch group 12 is an example of an operation unit in this disclosure and the operation control ECU 56 is an example of an operation control device and an operation device pertaining to this disclosure. Additionally, the left steering switch group 12 and the operation control ECU 56 are an example of a steering device pertaining to this disclosure. In this embodiment, the left steering switch group 12 and the operation control ECU 56 will be collectively called a "steering device 82."

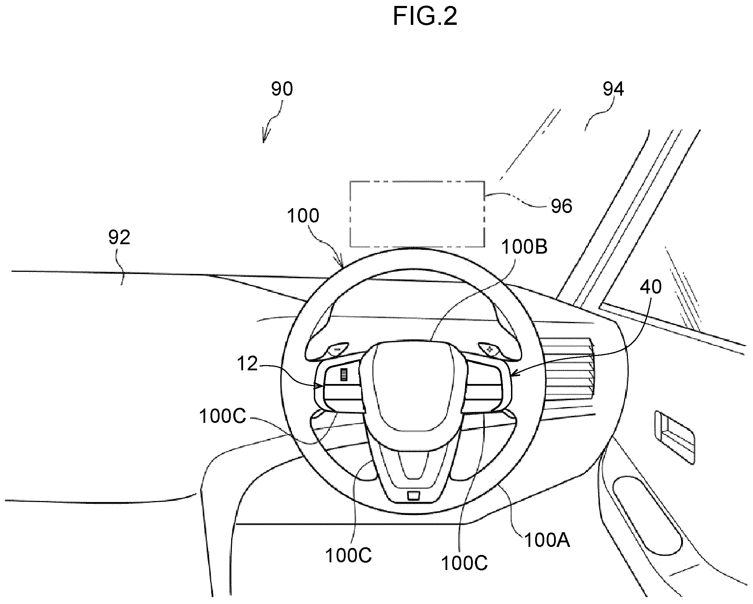

As illustrated in FIG. 2, the in-vehicle system 10 including the steering device 82 is installed in a vehicle 90. The vehicle 90 has a cabin in the front portion of which an instrument panel 92 is disposed. A windshield 94 is disposed on the front end portion of the instrument panel 92. The windshield 94 extends in the vehicle up and down direction and the vehicle width direction and partitions the cabin interior from the cabin exterior. The range of the windshield 94 denoted by reference sign 96 is a range in which images are projected by the HUD 74.

On the driver's seat side (that is, the vehicle right side) of the instrument panel 92, a steering wheel 100 is provided via a steering column not illustrated in the drawings. The steering wheel 100 includes a substantially annular rim portion 100A. On the inner peripheral side of the rim portion 100A, a hub portion 100B that configures a central portion of the steering wheel 100 is provided. The rim portion 100A and the hub portion 100B are interconnected by plural (for example, in this embodiment, three) spoke portions 100C.

The spoke portions 100C are provided in three locations, between the right side of the rim portion 100A and the hub portion 100B, between the left side of the rim portion 100A and the hub portion 100B, and between the lower side of the rim portion 100A and the hub portion 100B. Here, the left steering switch group 12 is provided on the spoke portion 100C between the left side of the rim portion 100A and the hub portion 100B. Furthermore, the right steering switch group 40 is provided on the spoke portion 100C between the right side of the rim portion 100A and the hub portion 100B.

As illustrated in FIG. 1, the left steering switch group 12 includes a thumbwheel switch 14, a left first tact switch 22, and a left second tact switch 32. Of these, the left first tact switch 22 and the left second tact switch 32 are each configured by contact detection switches. The left steering switch group 12 also includes a left first electrostatic sensor 34 and a left second electrostatic sensor 36.

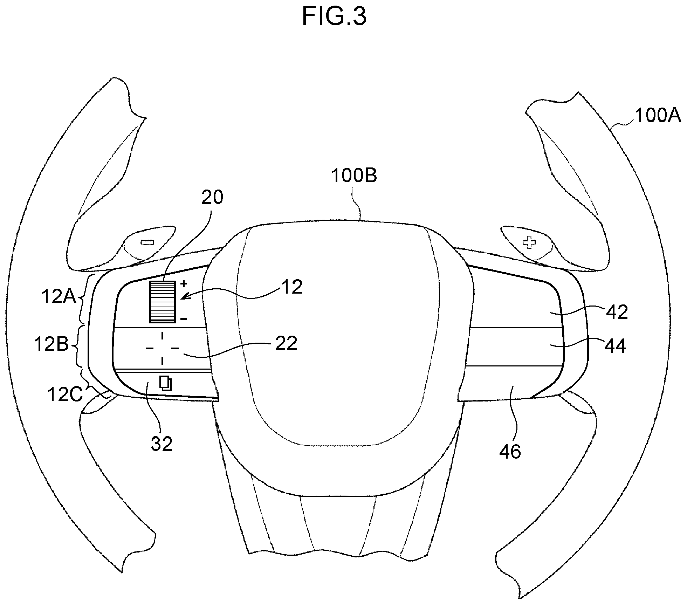

As illustrated in FIG. 3, an operation region of the left steering switch group 12 is partitioned, sequentially from above in the vehicle up and down direction, into three regions, a first operation region 12A, a second operation region 12B, and a third operation region 12C. The thumbwheel switch 14 is provided in the first operation region 12A in such a way that the rotational direction of a thumbwheel 20 with which the thumbwheel switch 14 is provided is oriented along the vehicle up and down direction. The thumbwheel switch 14 includes a rotation sensor 16, which detects rotational operations with respect to the thumbwheel 20, and a push switch 18, which detects push operations with respect to the thumbwheel 20. In this embodiment, the thumbwheel switch 14 is allocated the function of changing the volume of the audio device.

The left first tact switch 22 is provided in the second operation region 12B and, as illustrated in FIG. 1, includes an up switch 24, a down switch 26, a right switch 28, and a left switch 30. For this reason, the left first tact switch 22 is a four-way switch and configured so that it may be pushed in the four directions of up, down, right, and left. It will be noted that the switches 24 to 30 of the left first tact switch 22 are multifunction switches that may change the functions that are realized when they are pushed. In this embodiment, examples of the functions allocatable to the multifunction switches include phone calling functions, functions for changing the settings of the audio device (such as turning the power on and off, skipping ahead, going back, and switching operating modes), functions for changing the settings of the air conditioner (such as changing the temperature, the air volume, and the outlets, turning an automatic mode on and off, and switching between introducing outside air and recirculating the inside air).

The left first electrostatic sensor 34 is provided in the left first tact switch 22 and may detect that a user sitting in the driver's seat of the vehicle (hereinafter simply called "the user") has touched the left first tact switch 22. Specifically, the left first electrostatic sensor 34 may detect which of the up switch 24, the down switch 26, the right switch 28, and the left switch 30 of the left first tact switch 22 the user is touching.

The left second tact switch 32 is provided in the third operation region 12C and includes the left second electrostatic sensor 36. The left second electrostatic sensor 36 may detect that the user has touched the left second tact switch 32. In this embodiment, the left second tact switch 32 is allocated the function of switching the functions that are realized when the switches 24 to 30 of the left first tact switch 22 are pushed.

As illustrated in FIG. 1, the right steering switch group 40 includes a right first tact switch 42, a right second tact switch 44, and a right third tact switch 46. These are each configured by contact detection switches. The right steering switch group 40 also includes a right first electrostatic sensor 48, a right second electrostatic sensor 50, and a right third electrostatic sensor 52. As illustrated in FIG. 3, in the right steering switch group 40, the right first tact switch 42, the right second tact switch 44, and the right third tact switch 46 are disposed sequentially from above in the vehicle up and down direction.

The right first electrostatic sensor 48 is provided in the right first tact switch 42 and may detect that the user has touched the right first tact switch 42. The right second electrostatic sensor 50 is provided in the right second tact switch 44 and may detect that the user has touched the right second tact switch 44. The right third electrostatic sensor 52 is provided in the right third tact switch 46 and may detect that the user has touched the right third tact switch 46.

As illustrated in FIG. 1, the operation control ECU 56 includes a central processing unit (CPU) 58 and a memory 60 such as a read-only memory (ROM) and a random-access memory (RAM). The operation control ECU 56 also includes a nonvolatile storage unit 62 such as a hard disk drive (HDD) or a solid-state drive (SSD), a communication interface (I/F) 64, and an input/output interface (I/F) 66. The CPU 58, the memory 60, the storage unit 62, the communication interface 64, and the input/output interface 66 are communicably connected to each other via an internal bus 68.

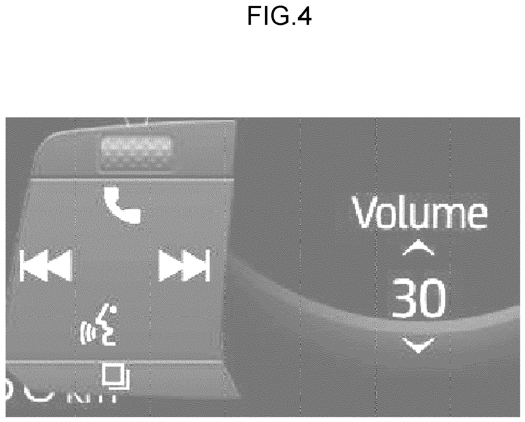

The storage unit 62 stores a function allocation table 72. In the function allocation table 72, the functions allocated to each of the switches of the switch groups 12 and 40 are registered. The operation control ECU 56 reads from the function allocation table 72 the functions allocated to each of the switches of the switch groups 12 and 40 and causes the HUD 74 and the meter display 76 to display, as images of the switch groups 12 and 40, images in which icons representing the functions it has read are arranged in the same way as in the switch groups 12 and 40. For example, FIG. 4 illustrates an example of an image of the switch group 12 displayed on the HUD 74 and the meter display 76.

Furthermore, when any of the switches among the switch groups 12 and 40 is operated, the operation control ECU 56 reads from the function allocation table 72 the function allocated to the switch that has been operated. The operation control unit ECU 56 notifies the on-board device 78 corresponding to the function it has read that execution of the function it has read has been instructed by an operation of the switch.

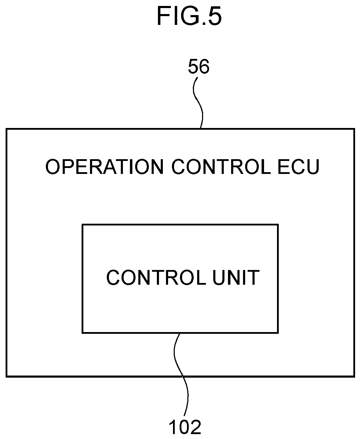

The storage unit 62 also stores an operation control program 70. The function control ECU 56 functions as a control unit 102 illustrates in FIG. 5 as a result of the operation control program 70 being read from the storage unit 62 and loaded to the memory 60 and the operation control program 70 that has been loaded to the memory 60 being executed by the CPU 58.

In a case in which the control unit 102 receives an operation in the direction of the second operation region 12B performed on the thumbwheel switch 14 provided in the first operation region 12A of the left steering switch group 12, the control unit 102 limits execution of processes corresponding to operations performed on the second operation region 12B until a predetermined condition is met. It will be noted that the operation control program 70 is an example of an operation control program pertaining to this disclosure.

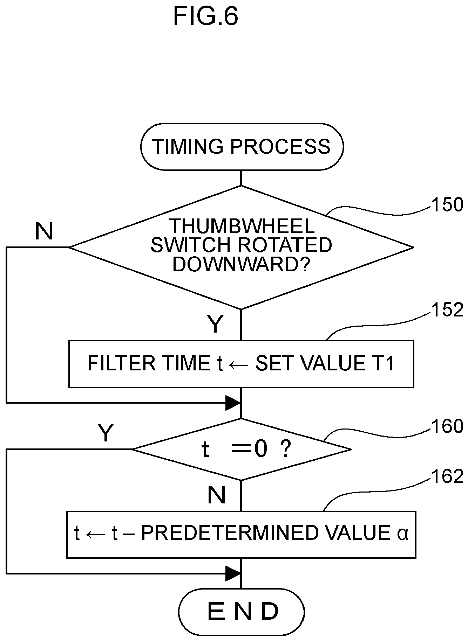

Next, as the operation of the first embodiment, first, a timing process repeatedly executed in predetermined cycles by the operation control ECU 56 (the control unit 102) while the ignition switch of the vehicle 90 is on will be described with reference to FIG. 6.

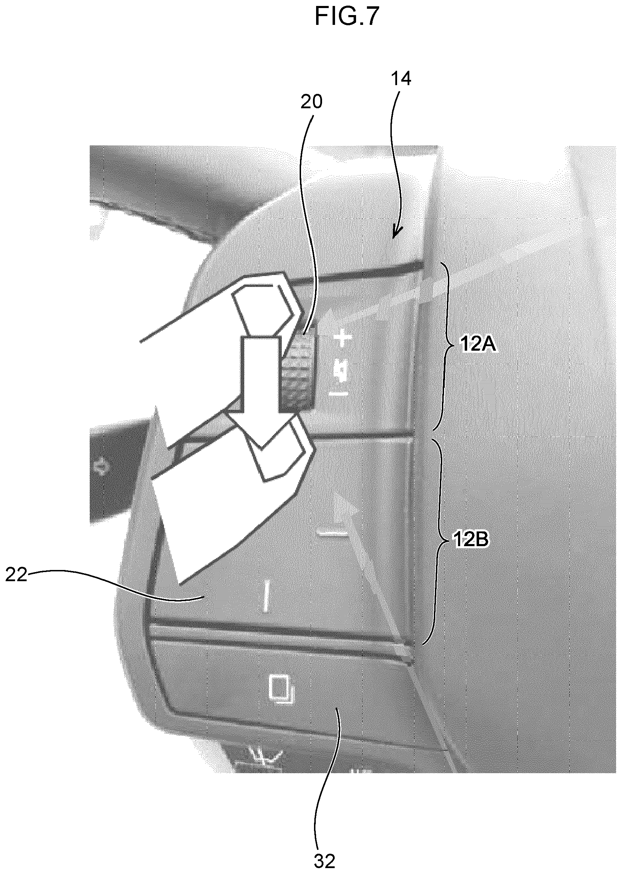

In step 150 of the timing process, the control unit 102 determines whether or not the thumbwheel 20 of the thumbwheel switch 14 has been rotated in the downward direction, that is, in the direction toward the second operation region 12B (the left first tact switch 22) (see also FIG. 7). In a case in which the determination in step 150 is yes, the control unit 102 moves to step 152. In step 152 the control unit 102 sets a predetermined value T1 as a filter time t, and then the control unit 102 moves to step 160. It will be noted that the initial value of the filter time t is 0 and the predetermined value T1 is a value corresponding to an amount of time of about several seconds. In a case in which the determination in step 150 is no, the control unit 102 skips step 152 and moves to step 160.

In step 160 the control unit 102 determines whether or not the filter time t is 0. In a case in which the determination in step 160 is yes, the control unit 102 ends the timing process. In a case in which the determination in step 160 is no, the control unit 102 moves to step 162. In step 162 the control unit 102 subtracts a predetermined value α from the filter time t, and then the control unit 102 ends the timing process. It will be noted that the predetermined value α is a value corresponding to the execution cycle of the timing process.

Because of the above timing process, as illustrated also in FIG. 7, in a case in which the thumbwheel 20 of the thumbwheel switch 14 is rotated in the downward direction, the relationship of filter time t ≠ 0 is set until an amount of time corresponding to the predetermined value T1 elapses since the thumbwheel 20 has been rotated. On the other hand, in a case in which the thumbwheel 20 is rotated in the upward direction and in a case in which a push operation is performed with respect to the thumbwheel 20, the relationship of filter time t = 0 is maintained as is.

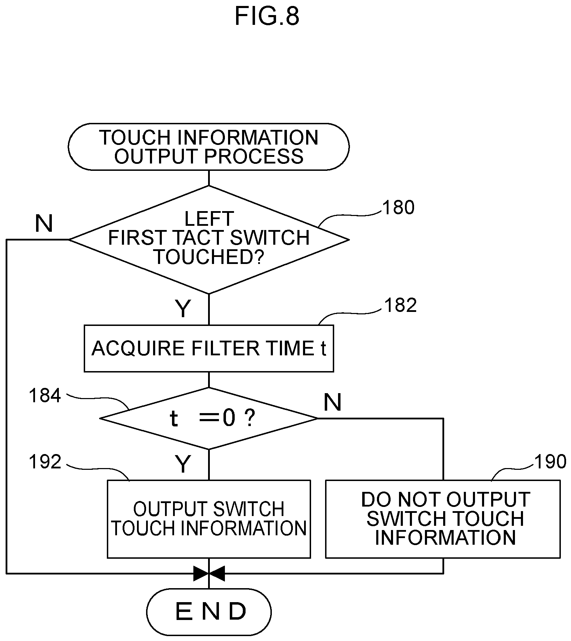

Next, a touch information output process repeatedly executed in predetermined cycles by the operation control ECU 56 (i.e., the control unit 102) while the ignition switch of the vehicle 90 is on will be described with reference to FIG. 8.

In step 180 of the touch information output process, the control unit 102 determines whether or not a touch operation has been performed with respect to the left first tact switch 22. In a case in which the determination in step 180 is no, the control unit 102 ends the touch information output process. In a case in which the determination in step 180 is yes, the control unit 102 moves to step 182.

In step 182 the control unit 102 acquires the filter time t that has been updated in the timing process. Then, in the next step 184 the control unit 102 determines whether or not the filter time t it acquired in step 182 is 0. In a case in which the determination in step 184 is no, the control unit 102 moves to step 190. Then, in step 190 the control unit 102 ends the touch information output process without outputting, to the in-vehicle devices 78 or the like, touch information indicating that a touch operation has been performed with respect to the left first tact switch 22.

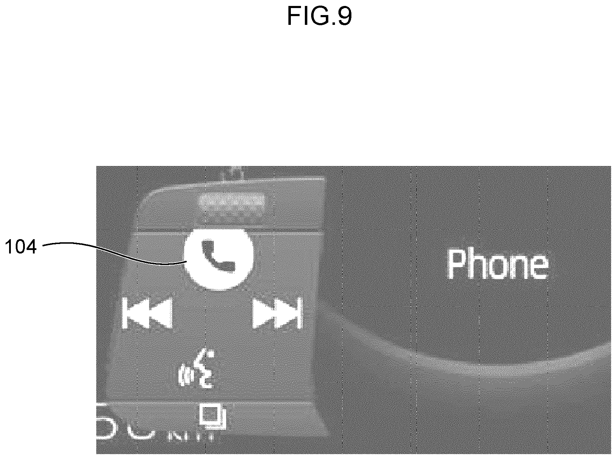

In a case in which the determination in step 184 is yes, the control unit 102 moves to step 192. In step 192 the control unit 102 outputs, to the in-vehicle devices 78 or the like, touch information indicating that a touch operation has been performed with respect to the left first tact switch 22. The control unit 102 also causes, as illustrated in FIG. 9 for example, an icon 104 corresponding to the up switch 24 of the left first tact switch 22 in the image of the left steering switch group 12 displayed on the HUD 74 and the meter display 76 to be reversely displayed. This allows the user to recognize that the touch operation with respect to the up switch 24 of the left first tact switch 22 has been received. Then, after the process of step 192 ends, the control unit 102 ends the touch information output process.

Because of the above touch information output process, while the filter time t ≠ 0, that is, until an amount of time corresponding to the predetermined value T1 elapses since the thumbwheel 20 has been rotated in the downward direction, touch information is not output even if a touch operation is performed with respect to the left first tact switch 22 and processes corresponding to touch operations with respect to the left first tact switch 22 (e.g., the process to reversely display the icon 104, etc.) are not executed.

In this way, in the first embodiment, in a case in which the control unit 102 receives an operation performed on the first operation region A in the direction of the second operation region 12B adjacent to the first operation region 12A of the left steering switch group 12 that includes the first operation region 12A and the second operation region 12B, the control unit 102 limits execution of processes corresponding to operations performed on the second operation region 12B until a predetermined condition is met. Because of this, execution of processes corresponding to unintended operations may be more effectively limited.

Furthermore, in the first embodiment, the control unit 102 does not limit execution of processes corresponding to operations performed on the second operation region 12B in a case in which the control unit 102 receives an operation performed on the first operation region 12A in a direction other than the direction of the second operation region 12B. Because of this, intended operations with respect to the second operation region 12B (the left first tact switch 22) may be inhibited from ending up being canceled.

Furthermore, in the first embodiment, the first operation region 12A is provided with the thumbwheel switch 14, and the control unit 102 limits execution of processes corresponding to operations performed on the second operation region 12B in a case in which the control unit 102 receives a rotational operation with respect to the thumbwheel switch 14 in the direction of the second operation region 12B. Because of this, in a configuration where the first operation region 12A is provided with the thumbwheel switch 14, execution of processes corresponding to unintended operations with respect to the second operation region 12B (the left first tact switch 22) may be more effectively inhibited.

Furthermore, in the first embodiment, the control unit 102 does not limit execution of processes corresponding to operations performed on the second operation region 12B in a case in which the control unit 102 receives at least one of a rotational operation with respect to the thumbwheel switch 14 in the opposite direction of the direction of the second operation region 12B and a push operation on the thumbwheel switch 14. Because of this, in a configuration where the first operation region 12A is provided with the thumbwheel switch 14, intended operations with respect to the second operation region 12B (the left first tact switch 22) may be inhibited from ending up being canceled.

Furthermore, in the first embodiment, the predetermined condition is a condition where a predetermined amount of time has elapsed. Because of this, limiting execution of processes corresponding to unintended operations with respect to the second operation region 12B (the left first tact switch 22) may be realized by a simple process.

### [Second Embodiment]

Next, a second embodiment of this disclosure will be described. It will be noted that the second embodiment has a similar configuration as the first embodiment, so parts are assigned the same reference signs, description of configurations is omitted, and the action of the second embodiment is described below.

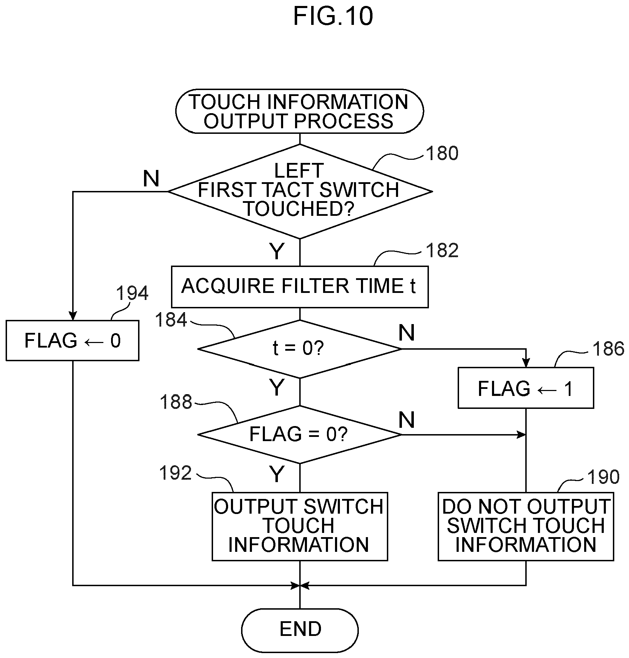

FIG. 10 illustrates a touch information output process pertaining to the second embodiment. In step 180 of the touch information output process, the control unit 102 determines whether or not a touch operation has been performed with respect to the left first tact switch 22. In a case in which the determination in step 180 is no, the control unit 102 moves to step 194. In step 194 the control unit 102 sets a flag to 0, and then the control unit 102 ends the touch information output process.

In a case in which the determination in step 180 is yes, the control unit 102 moves to step 182. In step 182 the control unit 102 acquires the filter time t. Then, in the next step 184 the control unit 102 determines whether or not the filter time t it acquired in step 182 is 0.

In a case in which the determination in step 184 is no, the control unit 102 moves to step 186. In step 186 the control unit 102 sets the flag to 1. Then, in step 190 the control unit 102 ends the touch information output process without outputting, to the in-vehicle devices 78 or the like, touch information indicating that a touch operation has been performed with respect to the left first tact switch 22.

In a case in which the determination in step 184 is yes, the control unit 102 moves to step 188. In step 188 the control unit 102 determines whether or not the flag is 0. In a case in which the determination in step 188 is no, the control unit 190 moves to step 190 and ends the touch information output process without outputting touch information to the in-vehicle devices 78 or the like. In a case in which the determination in step 188 is yes, the control unit 102 moves to step 192.

In step 192 the control unit 102 outputs, to the in-vehicle devices 78 or the like, touch information indicating that a touch operation has been performed with respect to the left first tact switch 22. Furthermore, the control unit 102 causes, as illustrated in FIG. 9 for example, the icon 104 corresponding to the up switch 24 of the left first tact switch 22 in the image of the switch group 12 displayed on the HUD 74 and the meter display 76 to be reversely displayed. Then, the control unit 102 ends the touch information output process.

Because of the above touch information output process, while the filter time t ≠ 0, that is, until an amount of time corresponding to the predetermined value T1 elapses since the thumbwheel 20 has been rotated in the downward direction, touch information is not output even if a touch operation is performed with respect to the left first tact switch 22 and processes corresponding to touch operations with respect to the left first tact switch 22 (e.g., the process to reversely display the icon 104, etc.) are not executed.

Furthermore, the flag is set to 1 while the filter time t ≠ 0, and the flag is set to 0 after a touch operation with respect to the left first tact switch 22 is discontinued (when the determination in step 180 is no). Consequently, in a case in which the filter time t = 0 and, after a touch operation with respect to the left first tact switch 22 has been discontinued once, a touch operation is performed again, touch information is output and the process corresponding to the touch operation with respect to the left first tact switch 22 is executed.

In this way, in the second embodiment, the predetermined condition is a condition where an operation performed on the second operation region 12B has been discontinued. Because of this, even in a case in which, after performing an operation with respect to the first operation region 12A in the direction of the second operation region 12B, the user continues an unintended operation with respect to the second operation region 12B (the left first tact switch 22), such as continuing to touch the second operation region 12B (the left first tact switch 22) for example, execution of the process corresponding to the unintended operation may be limited.

### [Third Embodiment]

Next, a third embodiment of this disclosure will be described. It will be noted that the third embodiment has a similar configuration as the first embodiment, so parts are assigned the same reference signs, description of configurations is omitted, and the action of the third embodiment is described below.

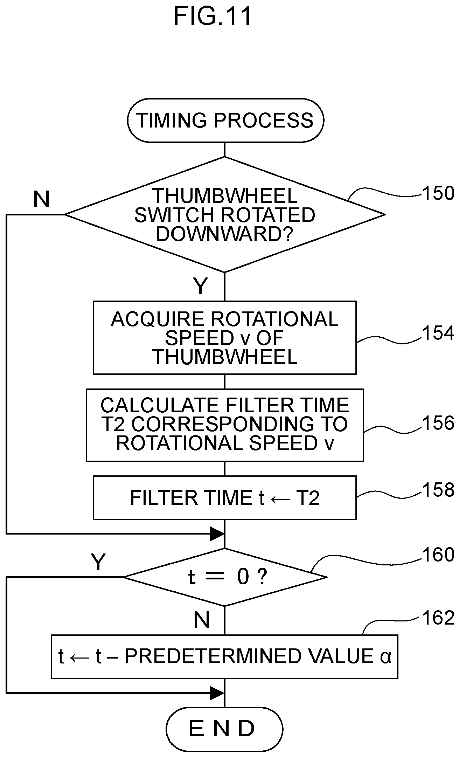

FIG. 11 illustrates a timing process pertaining to the third embodiment. In step 150 of the timing process, the control unit 102 determines whether or not the thumbwheel 20 of the thumbwheel switch 14 has been rotated in the downward direction. In a case in which the determination of step 150 is yes, the control unit 102 moves to step 154. In step 154 the control unit 102 acquires a rotational speed v of the thumbwheel 20 from the rotation sensor 16. It will be noted that in a case in which the rotation sensor 16 has a configuration where it outputs pulse signals with pulse numbers corresponding to the rotational amount of the thumbwheel 20, the rotational speed v of the thumbwheel 20 may be acquired by counting the pulse numbers per unit of time in the pulse signals.

Here, in the third embodiment, the relationship between the rotational speed v and a filter time T2 is predetermined so that as the rotational speed v of the thumbwheel 20 increases, the filter time T2 decreases. In the next step 156 the control unit 102 calculates the filter time T2 corresponding to the rotational speed v of the thumbwheel 20 it acquired in step 154 based on the above relationship. In step 158 the control 102 sets a predetermined value T2 as the filter time t, and then the control unit 102 moves to step 160.

In a case in which the determination in step 150 is no, the control unit 102 skips steps 154 to 158 and moves to step 160. The processes of step 160 on are the same as those in step 160, so description thereof will be omitted.

Because of the above timing process, in a case in which the thumbwheel 20 of the thumbwheel switch 14 is rotated in the downward direction, the relationship of filter time t ≠ 0 is set until the filter time T2 corresponding to the rotational speed v of the thumbwheel 20 elapses since the thumbwheel 20 has been rotated. On the other hand, in a case in which the thumbwheel 20 is rotated in the upward direction and in a case in which a push operation is performed with respect to the thumbwheel 20, the relationship of filter time t = 0 is maintained as is.

In this way, in the third embodiment, the predetermined condition is a condition where the filter time T2 decided in accordance with the speed of an operation performed on the first operation region 12A has elapsed. Because of this, it becomes possible to optimize, in accordance with the speed of operations performed on the first operation region 12A (the left first tact switch 22), the period of time in which the control unit 102 limits execution of processes corresponding to operations performed on the second operation region 12B (the left first tact switch 22).

Although in the above embodiment an aspect has been described where the thumbwheel switch 14 is allocated the function of adjusting the volume of the audio device, the disclosure is not limited to this. For example, the thumbwheel switch 14 may also be allocated another function, such as the function of adjusting the temperature setting of the air conditioner or the function of adjusting the air volume of the blower of the air conditioner.

Furthermore, in the above embodiment, an aspect has been described where the second operation region 12B is disposed on the lower side of the first operation region 12A, but the disclosure is not limited to this, and the second operation region 12B may also, for example, be provided on the upper side of the first operation region 12A. Furthermore, the thumbwheel 20 of the thumbwheel switch 14 may also be oriented so as to be rotatable in the vehicle right and left direction, and in this case the disclosure may be applied if the second operation region 12B is disposed on the left side or the right side of the first operation region 12A.

Furthermore, in the above embodiment, an aspect has been described where the left steering switch group 12, which is an example of an operation unit in the disclosure, is provided on the spoke portion 100C between the left side of the rim portion 100A and the hub portion 100B of the steering wheel 100. However, the disclosure is not limited to this, and the right steering switch group 40 provided on the spoke portion 100C between the right side of the rim portion 100A and the hub portion 100B of the steering wheel 100 may also serve as an example of the operation unit in the disclosure.

Moreover, in the above embodiment, an aspect has been described where, in a case in which the control unit 102 receives an operation performed on the first operation region 12A in the direction of the second operation region 12B, the control unit 102 limits execution of processes corresponding to operations performed on the second operation region 12B by not outputting touch information until a predetermined condition is met. However, the disclosure is not limited to this. For example, in a case in which the control unit 102 receives an operation performed on the first operation region 12A in the direction of the second operation region 12B, the control unit 102 may limit execution of processes corresponding to operations performed on the second operation region 12B by masking signals from switches or sensors provided in the second operation region 12B until a predetermined condition is met.

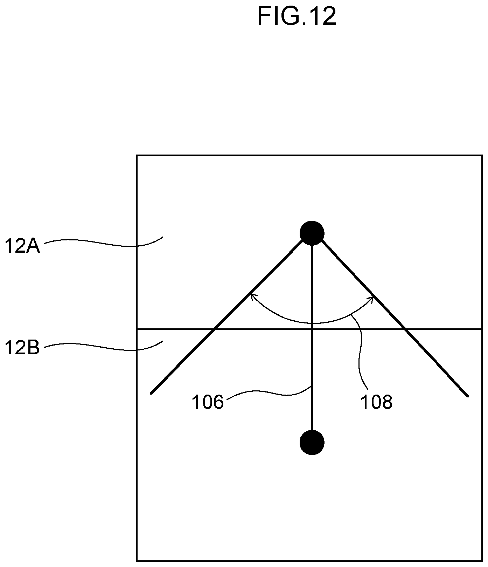

Furthermore, in the above embodiment, an aspect has been described where the first operation region 12A is provided with the thumbwheel switch 14, but the disclosure is not limited to this. For example, the first operation region 12A may be provided with a touch sensor or the like instead of the thumbwheel switch 14. In that case, regarding the range in which an operation performed on the first operation region 12A is regarded as an operation in the direction of the second operation region 12B, as illustrated in FIG. 12 for example, a range 108 of ±45° about a line 106 extending from the center of the first operation region 12A to the center of the second operation region 12B may be applied.

Furthermore, in the above embodiment, an aspect has been described where the left steering switch group 12, which is an example of an operation unit in the disclosure, is provided in the steering wheel 100. However, the disclosure is not limited to this, and the operation unit in the disclosure may be provided in a location other than the steering wheel 100, such as a center console, for example.

Furthermore, an aspect has been described where the operation control program 70, which is an example of an operation control program pertaining to the disclosure, is stored (installed) beforehand in the storage unit 62. However, it is also possible for the operation control program pertaining to the disclosure to be provided in a form in which it is recorded in a non-transitory recording medium such as an HDD, an SSD, and a DVD.

## Claims

1. An operation control device (56) comprising:
a memory (60); and
a processor (58) connected to the memory (60), **characterised in that** the processor is configured to:
in a case in which the processor (58) receives, at an operation unit (12, 40) that includes a first operation region (12A) and a second operation region (12B) adjacent to the first operation region (12A), an operation performed on the first operation region (12A) in a direction of the second operation region (12B), limit execution of processes corresponding to operations performed on the second operation region (12B) until a predetermined condition is met.

2. The operation control device (56) of claim 1, wherein the processor (58) is configured not to limit execution of processes corresponding to operations performed on the second operation region (12A) in a case in which the processor (56) receives an operation performed on the first operation region (12A) in a direction other than the direction of the second operation region (12B).

3. The operation control device (56) of claim 1, wherein
the first operation region (12A) comprises a wheel switch (20), and
the processor (58) is configured to limit execution of processes corresponding to operations performed on the second operation region (12A) in a case in which the processor (58) receives a rotational operation with respect to the wheel switch (20) in the direction of the second operation region (12B).

4. The operation control device (56) of claim 3, wherein the processor (58) is configured not to limit execution of processes corresponding to operations performed on the second operation region (12B) in a case in which the processor (58) receives at least one of a rotational operation with respect to the wheel switch (20) in the opposite direction of the direction of the second operation region (12B) or a push operation on the wheel switch (20).

5. The operation control device (56) of any one of claim 1 to claim 4, wherein the predetermined condition is a condition where a predetermined amount of time has elapsed.

6. The operation control device (56) of any one of claim 1 to claim 4, wherein the predetermined condition is a condition where an operation performed on the second operation region (12B) has been discontinued.

7. The operation control device (56) of claim 3 or claim 4, wherein the predetermined condition is a condition where an amount of time decided in accordance with the speed of an operation performed on the first operation region (12A) has elapsed.

8. An operation device comprising the operation control device (56) of claim 1.

9. A steering device (82) comprising:
a steering wheel (100) that comprises the operation unit (12, 40); and
the operation device of claim 8.

10. A vehicle (90) comprising the steering device (82) of claim 9.

11. An operation control method comprising:
in a case in which an operation unit (12, 40) that includes a first operation region (12A) and a second operation region (12B) adjacent to the first operation region (12A) receives an operation performed on the first operation region (12A) in a direction of the second operation region (12B), limiting execution of processes corresponding to operations performed on the second operation region (12B) until a predetermined condition is met.

12. A non-transitory storage medium storing a program that causes a computer to execute an operation control process, the operation control process comprising:
in a case in which an operation unit (12, 40) that includes a first operation region (12A) and a second operation region (12B) adjacent to the first operation region (12A) receives an operation performed on the first operation region (12A) in a direction of the second operation region (12B), limiting execution of processes corresponding to operations performed on the second operation region (12B) until a predetermined condition is met.

## Patentansprüche

1. Betriebssteuerungsvorrichtung (56), umfassend:
einen Speicher (60); und
einen Prozessor (58), der mit dem Speicher (60) verbunden ist, **dadurch gekennzeichnet, dass** der Prozessor zu Folgendem konfiguriert ist:
in einem Fall, in dem der Prozessor (58) an einer Betriebseinheit (12, 40), die einen ersten Betriebsbereich (12A) und einen zweiten Betriebsbereich (12B) angrenzend an den ersten Betriebsbereich (12A) beinhaltet, einen an dem ersten Betriebsbereich (12A) durchgeführten Vorgang in Richtung des zweiten Betriebsbereichs (12B) empfängt, Begrenzten einer Ausführung von Prozessen, die Vorgängen entsprechen, die an dem zweiten Betriebsbereich (12B) durchgeführt werden, bis eine vorbestimmte Bedingung erfüllt ist.

2. Betriebssteuerungsvorrichtung (56) nach Anspruch 1, wobei der Prozessor (58) konfiguriert ist, um eine Ausführung von Prozessen, die Vorgängen entsprechen, die an dem zweiten Betriebsbereich (12A) durchgeführt werden, in einem Fall nicht zu begrenzen, in dem der Prozessor (56) einen an dem ersten Betriebsbereich (12A) durchgeführten Vorgang in einer anderen Richtung als der Richtung des zweiten Betriebsbereichs (12B) empfängt.

3. Betriebssteuerungsvorrichtung (56) nach Anspruch 1, wobei
der erste Betriebsbereichs (12A) einen Radschalter (20) umfasst, und
der Prozessor (58) konfiguriert ist, um eine Ausführung von Prozessen, die Vorgängen entsprechen, die an dem zweiten Betriebsbereich (12A) ausgeführt werden, in einem Fall zu begrenzen, in dem der Prozessor (58) einen Drehvorgang in Bezug auf den Radschalter (20) in Richtung des zweiten Betriebsbereichs (12B) empfängt.

4. Betriebssteuerungsvorrichtung (56) nach Anspruch 3, wobei der Prozessor (58) konfiguriert ist, um eine Ausführung von Prozessen, die Vorgängen entsprechen, die an dem zweiten Betriebsbereich (12B) ausgeführt werden, in einem Fall nicht zu begrenzen, in dem der Prozessor (58) mindestens eines von einem Drehvorgang in Bezug auf den Radschalter (20) in der entgegengesetzten Richtung der Richtung des zweiten Betriebsbereichs (12B) oder einen Druckvorgang auf den Radschalter (20) empfängt;

5. Betriebssteuerungsvorrichtung (56) nach einem von Anspruch 1 bis Anspruch 4, wobei die vorbestimmte Bedingung eine Bedingung ist, bei der eine vorbestimmte Zeitspanne verstrichen ist.

6. Betriebssteuerungsvorrichtung (56) nach einem von Anspruch 1 bis Anspruch 4, wobei die vorbestimmte Bedingung eine Bedingung ist, bei der ein Betrieb unterbrochen wurde, der an dem zweiten Betriebsbereich (12B) ausgeführt wird.

7. Betriebssteuerungsvorrichtung (56) nach Anspruch 3 oder Anspruch 4, wobei die vorbestimmte Bedingung eine Bedingung ist, bei der eine Zeitspanne, die in Übereinstimmung mit der Geschwindigkeit eines an dem ersten Betriebsbereich (12A) durchgeführten Betriebs bestimmt wird, verstrichen ist.

8. Betriebsvorrichtung, umfassend die Betriebssteuerungsvorrichtung (56) nach Anspruch 1.

9. Lenkvorrichtung (82), umfassend:
ein Lenkrad (100), das die Betriebseinheit (12, 40) umfasst; und
die Betriebsvorrichtung nach Anspruch 8.

10. Fahrzeug (90), umfassend die Lenkvorrichtung (82) nach Anspruch 9.

11. Betriebssteuerungsverfahren, umfassend:
in einem Fall, in dem eine Betriebseinheit (12, 40), die einen ersten Betriebsbereich (12A) und einen an den ersten Betriebsbereich (12A) angrenzenden zweiten Betriebsbereich (12B) beinhaltet, einen an dem ersten Betriebsbereich (12A) durchgeführten Vorgang in Richtung des zweiten Betriebsbereichs (12B) empfängt, Begrenzen einer Ausführung von Prozessen, die Vorgängen entsprechen, die an dem zweiten Betriebsbereich (12B) durchgeführt werden, bis eine vorbestimmte Bedingung erfüllt ist.

12. Nicht-transitorisches Speichermedium, das ein Programm speichert, das einen Computer veranlasst, einen Betriebssteuerungsprozess auszuführen, der Betriebssteuerungsprozess umfassend:
in einem Fall, in dem eine Betriebseinheit (12, 40), die einen ersten Betriebsbereich (12A) und einen an den ersten Betriebsbereich (12A) angrenzenden zweiten Betriebsbereich (12B) beinhaltet, einen an dem ersten Betriebsbereich (12A) durchgeführten Vorgang in Richtung des zweiten Betriebsbereichs (12B) empfängt, Begrenzen einer Ausführung von Prozessen, die Vorgängen entsprechen, die an dem zweiten Betriebsbereich (12B) durchgeführt werden, bis eine vorbestimmte Bedingung erfüllt ist.

## Revendications

1. Dispositif de commande de fonctionnement (56) comprenant :
une mémoire (60) ; et
un processeur (58) relié à la mémoire (60), **caractérisé en ce que** le processeur est configuré pour :
dans un cas dans lequel le processeur (58) reçoit, au niveau d'une unité d'actionnement (12, 40) qui comprend une première zone d'actionnement (12A) et une deuxième zone d'actionnement (12B) adjacente à la première zone d'actionnement (12A), un actionnement réalisé sur la première zone d'actionnement (12A) dans la direction de la deuxième zone d'actionnement (12B), limiter l'exécution de processus correspondant à des actionnements réalisés sur la deuxième zone d'actionnement (12B) jusqu'à ce qu'une condition prédéterminée soit satisfaite.

2. Dispositif de commande de fonctionnement (56) selon la revendication 1, dans lequel le processeur (58) est configuré pour ne pas limiter l'exécution de processus correspondant à des actionnements réalisés sur la deuxième zone d'actionnement (12A) dans un cas dans lequel le processeur (56) reçoit un actionnement réalisé sur la première zone d'actionnement (12A) dans une direction autre que la direction de la deuxième zone d'actionnement (12B).

3. Dispositif de commande de fonctionnement (56) selon la revendication 1, dans lequel
la première zone d'actionnement (12A) comprend un commutateur à molette (20), et
le processeur (58) est configuré pour limiter l'exécution de processus correspondant à des actionnements réalisés sur la deuxième zone d'actionnement (12A) dans un cas dans lequel le processeur (58) reçoit un actionnement de rotation par rapport au commutateur à molette (20) dans la direction de la deuxième zone d'actionnement (12B).

4. Dispositif de commande de fonctionnement (56) selon la revendication 3, dans lequel le processeur (58) est configuré pour ne pas limiter l'exécution de processus correspondant à des actionnements réalisés sur la deuxième zone d'actionnement (12B) dans un cas dans lequel le processeur (58) reçoit au moins un d'un actionnement de rotation par rapport au commutateur à molette (20) dans la direction opposée à la direction de la deuxième zone d'actionnement (12B) ou d'un actionnement de poussée sur le commutateur à molette (20).

5. Dispositif de commande de fonctionnement (56) selon l'une quelconque des revendications 1 à 4, dans lequel la condition prédéterminée est une condition où un laps de temps prédéterminé s'est écoulé.

6. Dispositif de commande de fonctionnement (56) selon l'une quelconque des revendications 1 à 4, dans lequel la condition prédéterminée est une condition où un actionnement réalisé sur la deuxième zone d'actionnement (12B) a été interrompu.

7. Dispositif de commande de fonctionnement (56) selon la revendication 3 ou la revendication 4, dans lequel la condition prédéterminée est une condition où un laps de temps décidé en fonction de la vitesse d'un actionnement réalisé sur la première zone d'actionnement (12A) s'est écoulé.

8. Dispositif d'actionnement comprenant le dispositif de commande de fonctionnement (56) selon la revendication 1.

9. Dispositif de direction (82) comprenant :
un volant de direction (100) qui comprend l'unité d'actionnement (12, 40) ; et
le dispositif d'actionnement selon la revendication 8.

10. Véhicule (90) comprenant le dispositif de direction (82) selon la revendication 9.

11. Procédé de commande d'actionnement comprenant le fait de :
dans un cas dans lequel une unité d'actionnement (12, 40) qui comprend une première zone d'actionnement (12A) et une deuxième zone d'actionnement (12B) adjacente à la première zone d'actionnement (12A) reçoit un actionnement réalisé sur la première zone d'actionnement (12A) dans la direction de la deuxième zone d'actionnement (12B), limiter une exécution de processus correspondant à des actionnements réalisés sur la deuxième zone d'actionnement (12B) jusqu'à ce qu'une condition prédéterminée soit satisfaite.

12. Support de stockage non-transitoire stockant un programme qui amène un ordinateur à exécuter un processus de commande d'actionnement, le processus de commande de fonctionnement comprenant le fait de :
dans un cas dans lequel une unité d'actionnement (12, 40) qui comprend une première zone d'actionnement (12A) et une deuxième zone d'actionnement (12B) adjacente à la première zone d'actionnement (12A) reçoit un actionnement réalisé sur la première zone d'actionnement (12A) dans la direction de la deuxième zone d'actionnement (12B), limiter une exécution de processus correspondant à des actionnements réalisés sur la deuxième zone d'actionnement (12B) jusqu'à ce qu'une condition prédéterminée soit satisfaite.
